# EUROPÄISCHE PATENTSCHRIFT

(11) **EP 1 014 379 B1**
(45) Veröffentlichungstag und Bekanntmachung des Hinweises auf die Patenterteilung: **08.09.2004**
(21) Anmeldenummer: 99125422.8
(22) Anmeldetag: 20.12.1999
(51) Int. Cl.: G11C 8/00, H03K 19/094, H03M 5/16

(54) **Integrierte Schaltung mit einem Decoderelement**
Integrated circuit with decoder element
Circuit intégré avec un élément décodeur

(30) Priorität: 22.12.1998 DE 19859516
(43) Veröffentlichungstag der Anmeldung: 28.06.2000
(73) Patentinhaber: Infineon Technologies AG, 81669 München (DE)
(72) Erfinder: Hönigschmid, Heinz, 82343 Pöcking (DE); Braun, Georg, 80339 München (DE); Manyoki, Zoltan, 81739 München (DE); Röhr, Thomas, Dr., 85609 Aschheim (DE); Böhm, Thomas, 85604 Zorneding (DE)
(74) Vertreter: Epping Hermann & Fischer

(56) Entgegenhaltungen:
- WO-A-83/04353
- US-A- 4 465 945
- US-A- 5 274 278

## Beschreibung

Die Erfindung betrifft eine integrierte Schaltung mit einem Decoderelement zur Erzeugung eines Ausgangssignals mit drei unterschiedlichen Potentialen.

Der Erfindung liegt die Aufgabe zugrunde, eine integrierte Schaltung mit einem Decoderelement anzugeben, das in Abhängigkeit von Eingangssignalen ein Ausgangssignal mit drei unterschiedlichen Potentialen erzeugt.

Diese Aufgabe wird mit einer integrierten Schaltung gemäß Patentanspruch 1 gelöst. Vorteilhafte Aus- und Weiterbildungen der Erfindung sind Gegenstand abhängiger Ansprüche.

Die erfindungsgemäße integrierte Schaltung weist ein erstes Decoderelement auf, das einen Ausgang und fünf Anschlüsse aufweist. Das erste Decoderelement hat drei Betriebszustände, in denen es an dem Ausgang drei jeweils unterschiedliche Potentiale erzeugt, wobei das zweite Potential zwischen dem ersten und dem dritten Potential liegt. Der erste Anschluß ist über eine Reihenschaltung eines ersten Transistors eines ersten Leitungstyps, eines zweiten Transistors eines zweiten Leitungstyps und eines dritten Transistors des zweiten Leitungstyps mit dem zweiten Anschluß verbunden, wobei ein Schaltungsknoten zwischen dem ersten und dem zweiten Transistor mit dem Ausgang verbunden ist. Ein vierter Transistor des ersten Leitungstyps verbindet den Ausgang mit dem zweiten Potential. Der dritte Anschluß ist mit einem Steueranschluß des ersten Transistors verbunden. Der vierte Anschluß ist mit je einem Steueranschluß des zweiten und des vierten Transistors verbunden und der fünfte Anschluß ist mit einem Steueranschluß des dritten Transistors verbunden.

Die integrierte Schaltung ermöglicht mit ihrem ersten Decoderelement die Erzeugung der drei unterschiedlichen Potentiale in Abhängigkeit von an den fünf Anschlüssen des Decoderelementes anliegenden Signalen.

Nach einer Weiterbildung der Erfindung weist das erste Decoderelement einen fünften Transistor des zweiten Leitungstyps auf, der den Ausgang mit dem vierten Transistor verbindet. Somit ist der Ausgang über eine Reihenschaltung des fünften und des vierten Transistors mit dem zweiten Potential verbunden. Ein Steueranschluß des fünften Transistors ist mit einem festen Potential verbunden, das zwischen dem zweiten und dem dritten Potential liegt. Dies hat den Vorteil, daß der Substratanschluß (Bulk) des vierten Transistors auch bei Anliegen des dritten Potentials am Ausgang des Decoderelementes an das feste Potential angeschlossen werden kann, da der vierte Transistor nicht direkt, sondern über den fünften Transistor mit dem Ausgang verbunden ist. Somit ist die Gate-Substrat-Spannung und die Gate-Drain-Spannung des vierten Transistors in ihrer Höhe begrenzt, wodurch sein Gateoxid nur einer relativ geringen Belastung ausgesetzt ist. Hierdurch ist die Lebensdauer des vierten Transistors höher, als wenn der fünfte Transistor nicht vorhanden wäre.

Nach einer Weiterbildung der Erfindung weist die integrierte Schaltung eine Steuerschaltung auf, die mit den fünf Anschlüssen des Decoderelementes verbunden ist und die mehrere Betriebszustände hat, in denen sie an den fünf Anschlüssen Potentiale erzeugt, in deren Abhängigkeit das erste Decoderelement am Ausgang jeweils eines der drei unterschiedlichen Potentiale erzeugt.

Eine Weiterbildung der Erfindung sieht vor, daß die Steuerschaltung eine erste Inverterschaltung aufweist, die zwischen dem dritten und dem vierten Anschluß angeordnet ist. Dabei kann entweder der dritte Anschluß der Eingang und der vierte Anschluß der Ausgang des Inverters sein oder umgekehrt. Somit läßt sich durch die Steuerschaltung das Potential an einem dieser beiden Anschlüsse auf einfache Weise aus dem Potential am anderen Anschluß gewinnen. Es ist auch möglich, daß die Inverterschaltung einen Pegelumsetzer beinhaltet, so daß neben der Invertierung eine Pegelumsetzung erfolgt.

Alternativ oder zusätzlich zur ersten Inverterschaltung weist die Steuerschaltung nach einer Weiterbildung eine zweite Inverterschaltung auf, die zwischen dem ersten und dem fünften Anschluß angeordnet ist. Wiederum kann entweder der erste oder der fünfte Anschluß der Eingang der zweiten Inverterschaltung sein, und der jeweils andere Anschluß der Ausgang. Auch hier kann die zweite Inverterschaltung einen Pegelumsetzer aufweisen.

Weist die integrierte Schaltung ein zweites Decoderelement auf, das wie das erste Decoderelement aufgebaut ist, können die beiden Decoderelemente vorteilhafterweise eine erste Decodergruppe bilden, bei der jeweils die dritten und die vierten Anschlüsse der Decoderelemente miteinander verbunden sind. Dies ermöglicht eine gemeinsame Ansteuerung der Decoderelemente der ersten Decodergruppe über die miteinander verbundenen dritten und vierten Anschlüsse, während die Potentiale am ersten, zweiten und fünften Anschluß der beiden Decoderelemente unabhängig voneinander gesteuert werden.

Eine Weiterbildung sieht eine zweite Decodergruppe der integrierten Schaltung vor, die wie die erste Decodergruppe aufgebaut ist, wobei jeweils die ersten, die zweiten und die fünften Anschlüsse je eines der Decoderelemente der beiden Decodergruppen miteinander verbunden sind. Während also pro Decodergruppe die dritten und vierten Anschlüsse miteinander verbunden sind, sind bei jeweils einem Decoderelement aus jeder Decodergruppe die übrigen Anschlüsse miteinander verbunden, so daß sich insgesamt eine mit verhältnismäßig wenig Aufwand ansteuerbare Anordnung ergibt.

Die Erfindung wird im folgenden anhand der Figuren näher erläutert. Es zeigen:
- Figur 1: ein erstes Ausführungsbeispiel eines Decoderelementes der integrierten Schaltung,
- Figur 2: ein zweites Ausführungsbeispiel eines Decoderelementes,
- Figur 3: eine Steuerschaltung der integrierten Schaltung zur Ansteuerung eines der Decoderelemente aus Figur 1 oder 2,
- Figur 4: eine Tabelle, die die Abhängigkeit des Ausgangspotentials beim Decoderelement aus Figur 1 von den Potentialen an seinen fünf Anschlüssen zeigt,
- Figur 5: ein Ausführungsbeispiel der integrierten Schaltung, bei dem mehrere Decoderelemente zu zwei Decodergruppen zusammengefaßt sind,
- Figur 6: zwei Inverterschaltungen, die Bestandteil der Steuerschaltung aus Figur 3 sind und die zur Erzeugung von in Figur 5 eingezeichneten Signalen dienen,
- Figur 7: zeigt ein Ausführungsbeispiel einer Steuerschaltung zur Ansteuerung der in Figur 5 gezeigten Decoderelemente, und
- Figur 8: zeigt eine alternative Realisierung zur Figur 6.

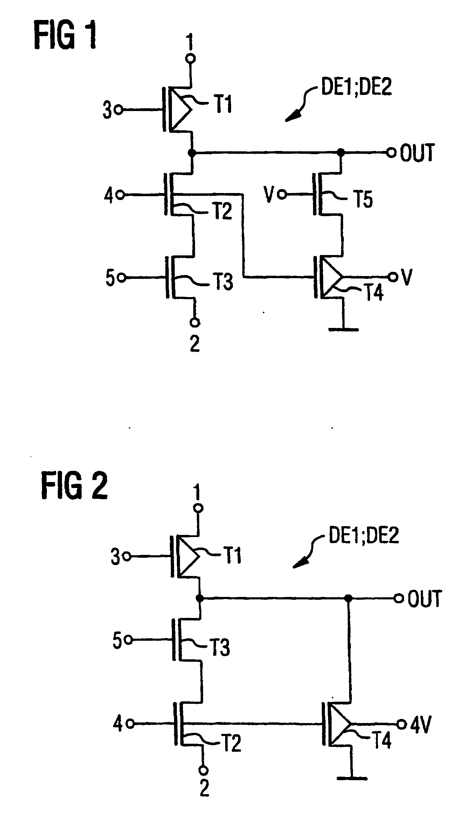

Figur 1 zeigt ein Decoderelement DE1; DE2 der integrierten Schaltung. Dieses weist fünf Anschlüsse 1,..,5 zum Anlegen von Steuersignalen und einen Ausgang OUT auf. Der erste Anschluß 1 ist über einen ersten Transistor T1 vom p-Kanal-Typ, einen zweiten Transistor T2 vom n-Kanal-Typ und einen dritten Transistor T3 vom n-Kanal-Typ mit dem zweiten Anschluß 2 verbunden. Die Drains des ersten T1 und zweiten T2 Transistors sind mit dem Ausgang OUT verbunden. Der Ausgang OUT ist außerdem über einen fünften Transistor T5 vom n-Kanal-Typ und einen vierten Transistor T4 vom p-Kanal-Typ mit Masse verbunden. Ein Steueranschluß des fünften Transistors T5 ist mit einem festen Potential V verbunden. Der dritte Anschluß 3 ist mit einem Steueranschluß des ersten Transistors T1, der vierte Anschluß 4 mit einem Steueranschluß des zweiten Transistors T2 und einem Steueranschluß des vierten Transistors T4 und der fünfte Anschluß 5 mit einem Steueranschluß des dritten Transistors T3 verbunden. Ein Substratanschluß des vierten Transistors T4 ist mit dem festen Potential V verbunden.

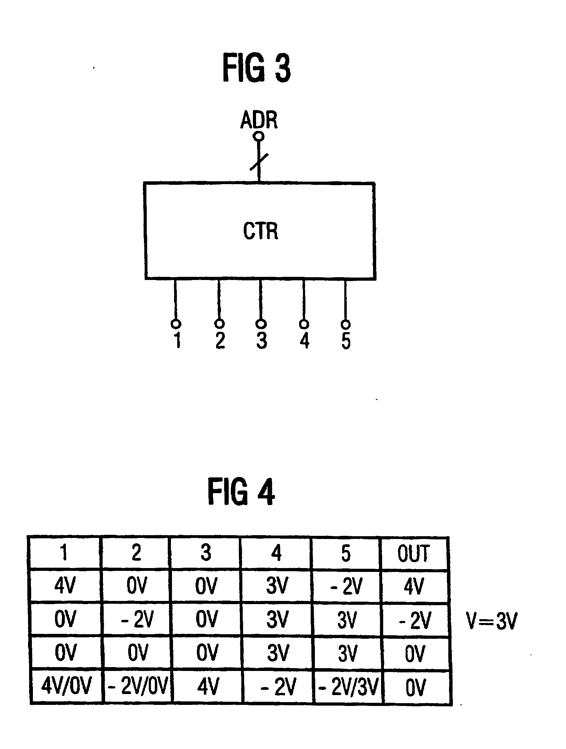

Figur 3 zeigt eine Steuerschaltung CTR der integrierten Schaltung, die Adreßeingänge ADR aufweist, die zum Anlegen von durch das Decoderelement in Figur 1 zu decodierenden Adressen dienen. Die Steuerschaltung CTR weist außerdem fünf Ausgänge auf, die mit je einem der fünf Anschlüsse 1,..,5 des Decoderelementes aus Figur 1 verbunden sind. Die Steuerschaltung CTR dient zur Erzeugung von vordecodierten Signalen an den fünf Anschlüssen 1,..,5 in Abhängigkeit der an ihren Adreßeingängen ADR anliegenden Adresse. Das Decoderelement aus Figur 1 sorgt anschließend für eine weitere Decodierung dieser vordecodierten Signale und erzeugt an seinem Ausgang OUT eines von drei unterschiedlichen Potentialen. Im vorliegenden Fall dient das Decoderelement in Figur 1 zur Erzeugung von -2V, 0V (Masse) und 4V am Ausgang OUT. Das feste Potential V ist bei diesem Ausführungsbeispiel gleich 3V.

Der genaue Aufbau der Steuerschaltung CTR ist für die Erfindung nicht wesentlich, und daher wird hierauf nicht weiter eingegangen. Wichtig ist nur, daß die Steuerschaltung CTR in der Lage ist, die im folgenden beschriebenen Potentiale an den fünf Anschlüssen 1,..,5 des Decoderelementes zu erzeugen.

Figur 4 zeigt eine Tabelle, die in ihren vier ersten Spalten die von der Steuerschaltung CTR erzeugten Steuerpotentiale an den Anschlüssen 1,..,5 und in der fünften Spalte das Ausgangspotential am Ausgang OUT des Decoderelementes aus Figur 1 beinhaltet. Anhand Figur 4 wird im folgenden die Funktionsweise des Decoderelementes aus Figur 1 erläutert. Zur Erzeugung von 4V am Ausgang OUT des Decoderelementes erzeugt die Steuerschaltung CTR am ersten Anschluß 1 4V, am zweiten Anschluß 2 und dritten Anschluß 3 0V, am vierten Anschluß 4 3V und am fünften Anschluß 5 -2V. Zur Erzeugung von -2V am Ausgang OUT des Decoderelementes erzeugt die Steuerschaltung CTR am ersten Anschluß 1 und am dritten Anschluß 3 0V, am zweiten Anschluß 2 -2V sowie am vierten Anschluß 4 und fünften Anschluß 5 jeweils 3V. Zur Erzeugung von 0V am Ausgang OUT des Decoderelementes erzeugt die Steuerschaltung CTR entweder an den ersten drei Anschlüssen 1, 2, 3 jeweils 0V und am vierten Anschluß 4 sowie am fünften Anschluß 5 jeweils 3V oder die Steuerschaltung CTR erzeugt am ersten Anschluß 1 wahlweise 4V oder 0V, am zweiten Anschluß 2 wahlweise -2V oder 0V, am dritten Anschluß 3 4V, am vierten Anschluß 4 -2V und am fünften Anschluß 5 wahlweise -2V oder 3V.

Mit dem in Figur 1 gezeigten Decoderelement ist es also möglich, die drei unterschiedlichen Potentiale -2V, 0V und 4V am Ausgang OUT zu erzeugen, ohne daß die Gate-Substrat(-Bulk)-Spannungen, die Gate-Source-Spannungen oder die Gate-Drain-Spannungen der Transistoren des Decoderelementes sehr groß werden. Im vorliegenden Fall beträgt die größte derartige Spannung 5V. Durch die in ihrer Höhe begrenzten Gate-Substrat-, Gate-Source- bzw. Gate-Drain-Spannungen der Transistoren T1 bis T5 beim Decoderelement aus Figur 1 wird deren Gate-Oxid nur relativ gering belastet, so daß diese Transistoren auch bei kleiner Dimensionierung eine relativ lange Lebensdauer haben.

Figur 2 zeigt ein anderes Ausführungsbeispiel des Decoderelementes, bei dem gegenüber Figur 1 die Position des zweiten T2 und dritten T3 Transistors vertauscht ist und bei der der vierte Transistor T4 direkt mit dem Ausgang OUT verbunden ist. Der Substratanschluß des vierten Transistors T4 ist mit 4V verbunden. Dieses Decoderelement eignet sich ebenfalls zur Erzeugung dreier unterschiedlicher Ausgangspotentiale. Jedoch muß hier das Potential am vierten Anschluß 4 gleich 4V gewählt werden, um den vierten Transistor T4 bei der Erzeugung von 4V am Ausgang OUT vollständig zu sperren. Liegt dann am zweiten Anschluß 2 -2V an, ergibt sich am zweiten Transistor T2 eine Gate-Source-Spannung und eine Gate-Substrat-Spannung von 6V, die beim Ausführungsbeispiel gemäß Figur 1 nicht auftritt. Somit ergibt sich eine größere Belastung des Gate-Oxids des zweiten Transistors T2.

In Abwandlung des Ausführungsbeispiels in Figur 2 kann auch das dort gezeigte Decoderelement zwischen dem vierten Transistor T4 und dem Ausgang OUT den in Figur 1 gezeigten fünften Transistor T5 aufweisen. Dann wird das zuvor beschriebene Problem am vierten Transistor T4 vermieden.

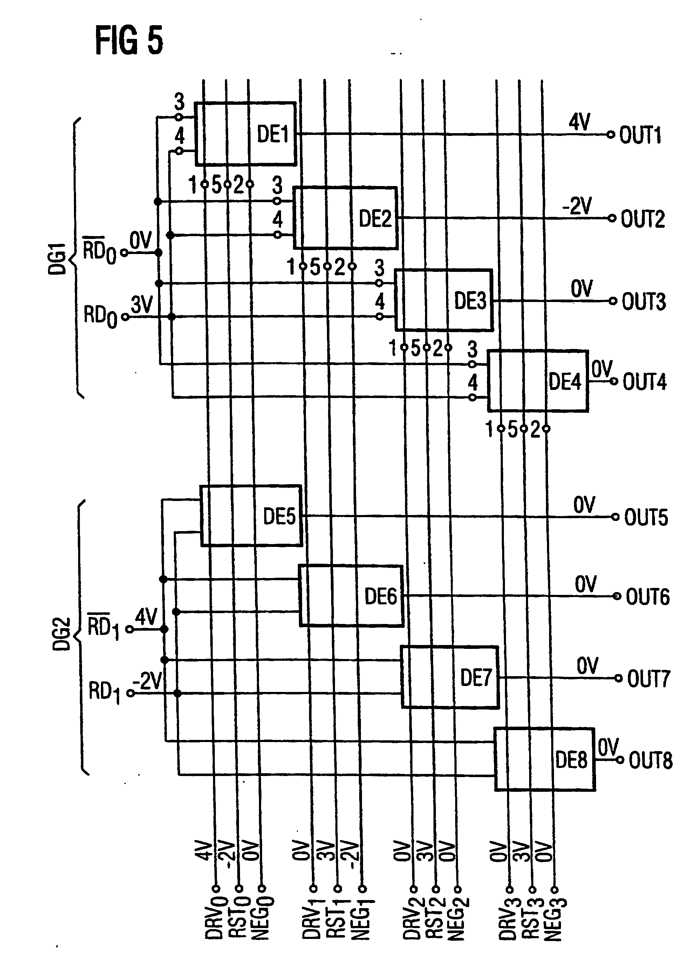

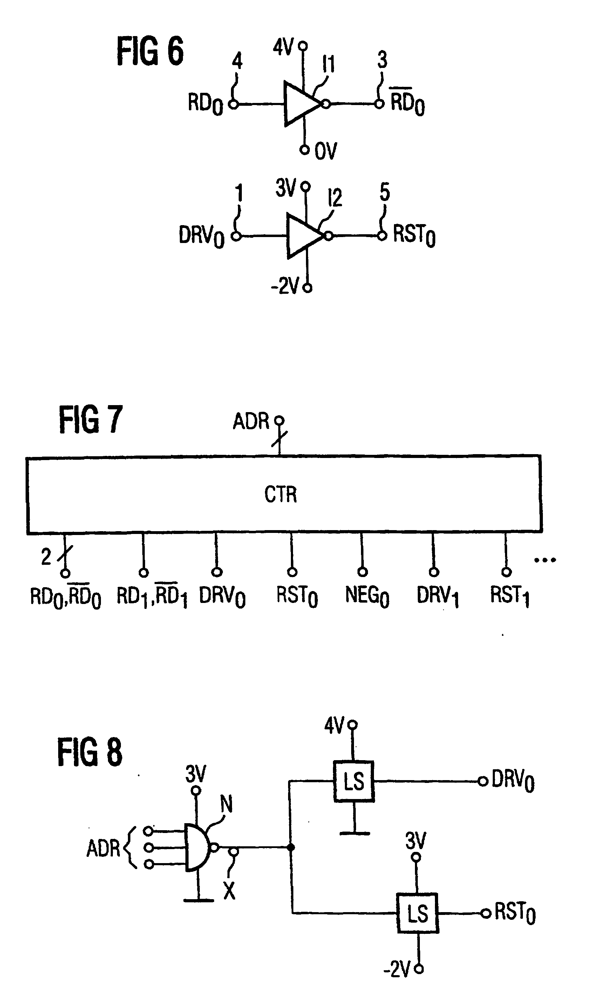

Figur 5 zeigt ein Ausführungsbeispiel der erfindungsgemäßen integrierten Schaltung, das acht Decoderelemente DEi gemäß Figur 1 enthält. Die ersten vier Decoderelemente DE1,..,DE4 bilden eine erste Decodergruppe DG1 und die letzten vier Decoderelemente DE5,..,DE8 bilden eine zweite Decodergruppe DG2 der integrierten Schaltung. Die Decoderelemente jeder Decodergruppe DG1, DG2 sind jeweils an ihren dritten Anschlüssen 3 und vierten Anschlüssen 4 miteinander verbunden. Die Steuerschaltung CTR, die zur Erzeugung der Potentiale an den fünf Anschlüssen dient, weist also für die dritten und vierten Anschlüsse der Decoderelemente jeder Decodergruppe DGi nur jeweils einen Ausgang auf (auf die Steuerschaltung CTR dieses Ausführungsbeispiels wird weiter unten bezüglich Figur 7 noch eingegangen). Dagegen weist die Steuerschaltung CTR jeweils getrennte Ausgänge auf zur Ansteuerung der ersten Anschlüsse 1, zweiten Anschlüsse 2 und fünften Anschlüsse 5 jedes Decoderelements DEi innerhalb einer der Decodergruppen DGi. Aus jeder Decodergruppe DGi sind der erste Anschluß 1, der zweite Anschluß 2 und der fünfte Anschluß 5 je eines der Decoderelemente DEi mit den entsprechenden Anschlüssen eines Decoderelementes aus der anderen Decodergruppe verbunden.

Insgesamt erzeugt die Steuerschaltung CTR die in Figur 5 eingezeichneten Steuersignale RDᵢ, /RDᵢ, DRVᵢ, RSTᵢ und NEGᵢ. In Figur 5 ist für einen Betriebszustand der Steuerschaltung CTR das Potential dieser Steuersignale eingezeichnet. Außerdem ist das sich daraus ergebende Ausgangspotential an den Ausgängen OUTi der Decoderelemente DEi entsprechend der Tabelle in Figur 4 eingezeichnet. Es ist erkennbar, daß mit der in Figur 5 dargestellten Schaltung in Abhängigkeit der von der Steuerschaltung CTR erzeugten Potentiale auf einfache Weise an einem ersten Ausgang OUT1 4V, an einem zweiten Ausgang OUT2 -2V und an allen übrigen Ausgängen OUT3 bis OUT8 0V erzeugt werden kann.

Figur 7 zeigt die Steuerschaltung CTR, mit der die in Figur 5 eingezeichneten Steuersignale erzeugt werden. Ebenso wie bei der Steuerschaltung aus Figur 3 erfolgt bei dieser die Generierung der Steuersignale an ihren Ausgängen durch Prädecodierung von an ihren Adreßeingängen ADR anliegenden Adressen.

Figur 6 zeigt eine erste Inverterschaltung I1 und eine zweite Inverterschaltung I2, die Bestandteil der in Figur 7 gezeigten Steuerschaltung CTR sind. Die erste Inverterschaltung I1 dient zur Erzeugung des Steuersignals /RD₀ am dritten Anschluß 3 aus dem Steuersignal RD₀ am vierten Anschluß 4 der Decoderelemente DE1 bis DE4 der ersten Decodergruppe DG1. Die erste Inverterschaltung I1 weist einen nicht genauer dargestellten Pegelumsetzer auf, der ihr Ausgangssignal /RD₀ mit einem niedrigen Pegel von 0V und einem hohen Pegel von 4V erzeugt, während ihr Eingangssignal RD₀ gemäß der Tabelle in Figur 4 am vierten Anschluß 4 einen niedrigen Pegel von -2V und einen hohen Pegel von 3V aufweist. Die zweite Inverterschaltung I2 dient zur Erzeugung des Steuersignals RST₀ aus dem Steuersignal DRV₀. Auch die zweite Inverterschaltung I2 weist einen Pegelumsetzer auf, der sein Ausgangssignal RST₀ mit einem niedrigen Pegel von -2V und mit einem hohen Pegel von 3V erzeugt, obwohl sein Eingangssignal DRV₀ am ersten Anschluß 1 gemäß der Tabelle in Figur 4 einen niedrigen Pegel von 0V und einen hohen Pegel von 4V aufweist.

Die Steuerschaltung CTR in Figur 7 weist pro Decodergruppe DGi eine erste Inverterschaltung I1 der in Figur 6 gezeigten Art und vier zweite Inverterschaltungen I2 der in Figur 6 gezeigten Art zur Erzeugung der zwei Signale /RDᵢ aus den zwei Eingangssignalen RDᵢ beziehungsweise der vier Ausgangssignale RSTᵢ aus den vier Eingangssignalen DRVᵢ auf.

Bei anderen Ausführungsbeispielen ist es auch möglich, daß gegenüber Figur 6 die Eingangs- und Ausgangssignale der Inverterschaltungen I1, I2 miteinander vertauscht sind, wobei der Pegelumsetzer jeweils angepaßt werden muß, so daß weiterhin die der Figur 4 entnehmbaren Pegel der Steuersignale an den Anschlüssen 1 bis 5 erzeugt werden können. Die Pegelumsetzung innerhalb der beiden Inverterschaltungen I1, I2 aus Figur 6 dient der Erzeugung der in der Figur 4 dargestellten Potentiale an den Anschlüssen 1 bis 5. Die Einhaltung dieser Potentiale gewährleistet, daß das Gate-Oxid der Transistoren T1 bis T5 nicht zu stark belastet wird, da somit ihre Gate-Source-Spannungen beziehungsweise Gate-Drain-Spannungen in der Höhe begrenzt werden.

Figur 8 zeigt eine zu Figur 6 alternative Variante für die Erzeugung der Steuersignale DRV₀, RST₀, die Bestandteil der Steuerschaltung CTR ist. Einem NAND-Gatter N wird ein Teil der Adreßbits ADR zugeführt. Es erzeugt in deren Abhängigkeit ein Zwischensignal X mit den Pegeln 0V und 3V. Das Zwischensignal X wird zwei Pegelwandlern LS zugeführt. Der eine Pegelwandler erzeugt aus dem Zwischensignal X das Steuersignal DRV₀ mit Pegeln von 0V bzw. 4V und der andere Pegelwandler erzeugt das Steuersignal RST₀ mit Pegeln von -2V bzw. 3V. Zur Erzeugung der Steuersignale RD₀ und /RD₀ kann eine gleichartige Schaltung vorgesehen sein.

## Patentansprüche

1. Integrierte Schaltung mit einem ersten Decoderelement (DE1), das drei Betriebszustände hat, in denen es an einem Ausgang (OUT) drei jeweils unterschiedliche Potentiale (-2V, 0V, 4V) erzeugt, wobei das zweite Potential (0V) zwischen dem ersten (-2V) und dem dritten (4V) Potential liegt, mit folgenden Merkmalen:
- ein erster Anschluß (1) des ersten Decoderelementes (DE1) ist über eine Reihenschaltung eines ersten Transistors (T1) eines ersten Leitungstyps, eines zweiten Transistors (T2) eines zweiten Leitungstyps und eines dritten Transistors (T3) des zweiten Leitungstyps mit einem zweiten Anschluß (2) verbunden, wobei ein Schaltungsknoten zwischen dem ersten (T1) und dem zweiten (T2) Transistor mit dem Ausgang (OUT) des ersten Decoderelementes (DE1) verbunden ist,
- ein vierter Transistor (T4) des ersten Leitungstyps verbindet den Ausgang (OUT) mit dem zweiten Potential (0V),
- ein dritter Anschluß (3) des ersten Decoderelementes (DE1) ist mit einem Steueranschluß des ersten Transistors (T1) verbunden,
- ein vierter Anschluß (4) des ersten Decoderelementes (DE1) ist mit je einem Steueranschluß des zweiten (T2) und des vierten (T4) Transistors verbunden,
- und ein fünfter Anschluß (5) des ersten Decoderelementes (DE1) ist mit einem Steueranschluß des dritten Transistors (T3) verbunden.

2. Integrierte Schaltung nach Anspruch 1,
deren erstes Decoderelement (DE1) einen fünften Transistor (T5) des zweiten Leitungstyps aufweist, der den Ausgang (OUT) mit dem vierten Transistor (T4) verbindet und dessen Steueranschluß mit einem festen Potential (V) verbunden ist, das zwischen dem zweiten (0V) und dem dritten (4V) Potential liegt.

3. Integrierte Schaltung nach Anspruch 1,
mit einer Steuerschaltung (CTR), die mit den fünf Anschlüssen (1, 2, 3, 4, 5) des ersten Decoderelementes (DE1) verbunden ist und die mehrere Betriebszustände hat, in denen sie an den fünf Anschlüssen Potentiale erzeugt, in deren Abhängigkeit das erste Decoderelement am Ausgang (OUT) jeweils eines der drei unterschiedlichen Potentiale (-2V, 0V, 4V) erzeugt.

4. Integrierte Schaltung nach Anspruch 3,
deren Steuerschaltung (CTR) einen ersten Betriebszustand hat, in dem sie zur Erzeugung des ersten Potentials (-2V) durch das erste Decoderelement (DE1) am ersten (1) und am dritten (3) Anschluß das zweite Potential (0V), am zweiten Anschluß (2) das erste Potential (-2V) sowie am vierten (4) und fünften (5) Anschluß ein viertes Potential (3V), das zwischen dem zweiten (0V) und dem dritten (4V) Potential liegt, erzeugt.

5. Integrierte Schaltung nach Anspruch 3,
deren Steuerschaltung (CTR) einen zweiten Betriebszustand hat, in dem sie zur Erzeugung des zweiten Potentials (0V) durch das erste Decoderelement (DE1) am ersten (1), am zweiten (2) und am dritten (3) Anschluß das zweite Potential (0V) sowie am vierten (4) und fünften (5) Anschluß ein viertes Potential (3V), das zwischen dem zweiten (0V) und dem dritten (4V) Potential liegt, erzeugt.

6. Integrierte Schaltung nach Anspruch 3,
deren Steuerschaltung (CTR) einen dritten Betriebszustand hat, in dem sie zur Erzeugung des zweiten Potentials (0V) durch das erste Decoderelement (DE1) am ersten Anschluß (1) das zweite (0V) oder das dritte (4V) Potential, am zweiten Anschluß (2) das erste (-2V) oder das zweite (0V) Potential, am dritten Anschluß (3) das dritte Potential (4V), am vierten Anschluß (4) das erste Potential (-2V) und am fünften Anschluß (5) das erste Potential (-2V) oder ein viertes (3V) Potential, das zwischen dem zweiten (0V) und dem dritten (4V) Potential liegt, erzeugt.

7. Integrierte Schaltung nach Anspruch 3,
deren Steuerschaltung (CTR) einen vierten Betriebszustand hat, in dem sie zur Erzeugung des dritten Potentials (4V) durch das erste Decoderelement (DE1) am ersten Anschluß (1) das dritte Potential (4V), am zweiten (2) und am dritten (3) Anschluß das zweite Potential (0V), am vierten Anschluß (4) ein viertes Potential (3V), das zwischen dem zweiten (0V) und dem dritten (4V) Potential liegt, sowie am fünften Anschluß (5) das erste Potential (-2V) erzeugt.

8. Integrierte Schaltung nach Anspruch 3,
deren Steuerschaltung (CTR) eine erste Inverterschaltung (I1) aufweist, die zwischen dem dritten (3) und dem vierten (4) Anschluß angeordnet ist.

9. Integrierte Schaltung nach Anspruch 3,
deren Steuerschaltung (CTR) eine zweite Inverterschaltung (I2) aufweist, die zwischen dem ersten (1) und dem fünften (5) Anschluß angeordnet ist.

10. Integrierte Schaltung nach Anspruch 1,
mit einem zweiten Decoderelement (DE2), das wie das erste Decoderelement (DE1) aufgebaut ist, wobei die beiden Decoderelemente (DE1, DE2) eine erste Decodergruppe (DG1) bilden, bei der jeweils die dritten (3) und die vierten (4) Anschlüsse der Decoderelemente (DE1, DE2) miteinander verbunden sind.

11. Integrierte Schaltung nach Anspruch 10,
- die eine zweite Decodergruppe (DG2) aufweist, die wie die erste Decodergruppe (DG1) aufgebaut ist,
- und bei der jeweils die ersten (1), die zweiten (2) und die fünften (5) Anschlüsse je eines der Decoderelemente (DE1, DE2) der beiden Decodergruppen (DG1, DG2) miteinander verbunden sind.

## Claims

1. Integrated circuit having a first decoder element (DE1), which has three operating states in which it generates three respectively different potentials (-2V, 0V, 4V) at an output (OUT), the second potential (OV) lying between the first (-2V) and the third (4V) potential, having the following features:
- a first terminal (1) of the first decoder element (DE1) is connected to a second terminal (2) via a series circuit formed by a first transistor (T1) of a first conduction type, a second transistor (T2) of a second conduction type and a third transistor (T3) of the second conduction type, a circuit node between the first (T1) and the second (T2) transistor being connected to the output (OUT) of the first decoder element (DE1),
- a fourth transistor (T4) of the first conduction type connects the output (OUT) to the second potential (0V),
- a third terminal (3) of the first decoder element (DE1) is connected to a control terminal of the first transistor (T1),
- a fourth terminal (4) of the first decoder element (DE1) is connected to a respective control terminal of the second (T2) and of the fourth (T4) transistor,
- and a fifth terminal (5) of the first decoder element (DE1) is connected to a control terminal of the third transistor (T3).

2. Integrated circuit according to Claim 1,
whose first decoder element (DE1) has a fifth transistor (T5) of the second conduction type, which connects the output (OUT) to the fourth transistor (T4) and whose control terminal is connected to a fixed potential (V), which lies between the second (0V) and the third (4V) potential.

3. Integrated circuit according to Claim 1, having a control circuit (CTR), which is connected to the five terminals (1, 2, 3, 4, 5) of the first decoder element (DE1) and has a plurality of operating states in which it generates, at the five terminals, potentials as a function of which the first decoder element respectively generates one of the three different potentials (-2V, 0V, 4V) at the output (OUT).

4. Integrated circuit according to Claim 3,
whose control circuit (CTR) has a first operating state, in which, for the generation of the first potential (-2V) by the first decoder element (DE1), said control circuit generates the second potential (OV) at the first (1) and at the third (3) terminal, the first potential (-2V) at the second terminal (2), and also a fourth potential (3V) at the fourth (4) and fifth (5) terminal, which fourth potential lies between the second (0V) and the third (4V) potential.

5. Integrated circuit according to Claim 3,
whose control circuit (CTR) has a second operating state, in which, for the generation of the second potential (0V) by the first decoder element (DE1), said control circuit generates the second potential (0V) at the first (1), at the second (2) and at the third (3) terminal, and also a fourth potential (3V) at the fourth (4) and fifth (5) terminal, which fourth potential lies between the second (0V) and the third (4V) potential.

6. Integrated circuit according to Claim 3,
whose control circuit (CTR) has a third operating state, in which, for the generation of the second potential (0V) by the first decoder element (DE1), said control circuit generates the second (0V) or the third (4V) potential at the first terminal (1), the first (-2V) or the second (0V) potential at the second terminal (2), the third potential (4V) at the third terminal (3), the first potential (-2V) at the fourth terminal (4), and the first potential (-2V) or a fourth (3V) potential at the fifth terminal (5), which fourth potential lies between the second (0V) and the third (4V) potential.

7. Integrated circuit according to Claim 3,
whose control circuit (CTR) has a fourth operating state, in which, for the generation of the third potential (4V) by the first decoder element (DE1), said control circuit generates the third potential (4V) at the first terminal (1), the second potential (0V) at the second (2) and at the third (3) terminal, a fourth potential (3V) at the fourth terminal (4), which fourth potential lies between the second (0V) and the third (4V) potential, and also the first potential (-2V) at the fifth terminal (5).

8. Integrated circuit according to Claim 3,
whose control circuit (CTR) has a first inverter circuit (I1), which is arranged between the third (3) and the fourth (4) terminal.

9. Integrated circuit according to Claim 3,
whose control circuit (CTR) has a second inverter circuit (I2) which is arranged between the first (1) and the fifth (5) terminal.

10. Integrated circuit according to Claim 1,
having a second decoder element (DE2), which is constructed like the first decoder element (DE1), the two decoder elements (DE1, DE2) forming a first decoder group (DG1), in which the third (3) and the fourth (4) terminals of the decoder elements (DE1, DE2) are in each case connected to one another.

11. Integrated circuit according to Claim 10,
- which has a second decoder group (DG2) which is constructed like the first decoder group (DG1),
- and in which the first (1), the second (2) and the fifth (5) terminals of each of the decoder elements (DE1, DE2) of the two decoder groups (DG1, DG2) are in each case connected to one another.

## Revendications

1. Circuit intégré comprenant un premier élément (DE1) de décodeur qui a trois états de fonctionnement, dans lesquels il se produit à une sortie (OUT) trois potentiels (-2V, OV, 4V) respectivement différents, le deuxième potentiel (OV) se trouvant entre le premier potentiel (-2V) et le troisième potentiel (4V), ayant les caractéristiques suivantes :
- une première borne (1) du premier élément (DE1) de décodeur est reliée par un circuit série d'un premier transistor (T1) d'un premier type de conductivité, d'un deuxième transistor (T2) d'un deuxième type de conductivité et d'un troisième transistor (T3) du deuxième type de conductivité, à une deuxième borne (2), un noeud du circuit compris entre le premier transistor (T1) et le deuxième transistor (T2) étant relié à la sortie (OUT) du premier élément (DE1) de décodeur,
- un quatrième transistor (T4) du premier type de conductivité relie la sortie (OUT) au deuxième potentiel (OV),
- une troisième borne (3) du premier élément (DE1) de décodeur est reliée à une borne de commande du premier transistor (T1),
- une quatrième borne (4) du premier élément (DE1) de décodeur est reliée à respectivement une borne de commande du deuxième transistor (T2) et du quatrième transistor (T4),
- et une cinquième borne (5) du premier élément (DE1) de décodeur est reliée à une borne de commande du troisième transistor (T3).

2. Circuit intégré suivant la revendication 1,
dont le premier élément (DE1) de décodeur a un cinquième transistor (T5) du deuxième type de conductivité, qui relie la sortie (OUT) au quatrième transistor (T4) et dont la borne de commande est reliée à un potentiel (V) fixe qui se trouve entre le deuxième potentiel (OV) et le troisième potentiel (4V).

3. Circuit intégré suivant la revendication 1,
comprenant un circuit (CTR) de commande, qui est relié aux cinq bornes (1, 2, 3, 4, 5) du premier élément (DE1) de décodeur et qui a plusieurs états de fonctionnement, dans lesquels il produit sur les cinq bornes des potentiels en fonction desquels le premier élément de décodeur produit à la sortie (OUT) respectivement l'un des trois potentiels ( -2V, OV, 4V) différents.

4. Circuit intégré suivant la revendication 3,
dont le circuit (CTR) de commande a un premier état de fonctionnement, dans lequel il produit, pour la production du premier potentiel (-2V), par le premier élément (DE1) de décodeur sur la première borne (1) et sur la troisième borne (3) le deuxième potentiel (OV), sur la deuxième borne (2) le premier potentiel (-2V), ainsi que sur la quatrième borne (4) et la cinquième borne (5) un quatrième potentiel (3V) qui se trouve entre le deuxième potentiel (OV) et le troisième potentiel (4V).

5. Circuit intégré suivant la revendication 3,
dont le circuit (CTR) de commande a un deuxième état de fonctionnement, dans lequel il produit, pour la production du deuxième potentiel (OV) par le premier élément (DE1) de décodeur sur la première borne (1), sur la deuxième borne (2) et sur la troisième borne (3), le deuxième potentiel (OV), ainsi que sur la quatrième borne (4) et la cinquième borne (5) un quatrième potentiel (3V) qui se trouve entre le deuxième potentiel (OV) et le troisième potentiel (4V).

6. Circuit intégré suivant la revendication 3,
dont le circuit (CTR) de commande a un troisième état de fonctionnement dans lequel il produit pour la production du deuxième potentiel (OV), par le premier élément (DE1) de décodeur sur la première borne (1) le deuxième potentiel (OV) ou le troisième potentiel (4V), sur la deuxième borne (2) le premier potentiel (-2V) ou le deuxième potentiel (OV), sur la troisième borne (3), le troisième potentiel (4V), sur la quatrième borne (4) le premier potentiel (-2V) et sur la cinquième borne (5) le premier potentiel (-2V) ou un quatrième potentiel (3V) qui se trouve entre le deuxième potentiel (OV) et le troisième potentiel (4V).

7. Circuit intégré suivant la revendication 3,
dont le circuit (CTR) de commande a un quatrième état de fonctionnement dans lequel il produit pour la production du troisième potentiel (4V), par le premier élément (DE1) de décodeur sur la première borne (1) le troisième potentiel (4V) sur la deuxième borne (2) et la troisième borne (3) le deuxième potentiel (OV), sur la quatrième borne (4) un quatrième potentiel (3V) qui se trouve entre le deuxième potentiel (OV) et le troisième potentiel (4V), ainsi que sur la cinquième borne (5) le premier potentiel (-2V).

8. Circuit intégré suivant la revendication 3,
dont le circuit (CTR) de commande comporte un premier circuit (I1) inverseur qui est disposé entre la troisième borne (3) et la quatrième borne (4).

9. Circuit intégré suivant la revendication 3,
dont le circuit (CTR) de commande comporte un deuxième circuit (I2) inverseur qui est disposé entre la première borne (1) et la cinquième borne (5).

10. Circuit intégré suivant la revendication 1,
comprenant un deuxième élément (DE2) de décodeur qui est constitué comme le premier élément (DE1) de décodeur, les deux éléments (DE1, DE2) de décodeur formant un premier groupe (DG1) de décodeur, dans lequel respectivement les troisièmes bornes (3) et les quatrièmes bornes (4) des éléments (DE1, DE2) de décodeur sont reliées entre elles.

11. Circuit intégré suivant la revendication 10,
- qui a un deuxième groupe (DG2) de décodeur qui est constitué comme le premier groupe (DG1) de décodeur,
- et dans lequel respectivement les premières bornes (1), les deuxièmes bornes (2) et les cinquièmes bornes (5) de respectivement l'un des éléments (DE1, DE2) de décodeur des deux groupes (DG1, DG2) de décodeur sont reliées entre elles.
